# EUROPÄISCHE PATENTANMELDUNG

(11) **EP 4 560 328 A1**
(43) Veröffentlichungstag der Anmeldung: **28.05.2025**
(21) Anmeldenummer: 23212075.8
(22) Anmeldetag: 24.11.2023
(51) Int. Cl.: G01R 31/12

(54) **ELEKTRISCHER HOCHSPANNUNGSLEITER SOWIE VERFAHREN ZUR PRÜFUNG VON HOCHSPANNUNGSANLAGEN**

(71) Anmelder: Fachkommission für Hochspannungsfragen (FKH), 8050 Zürich (CH)
(72) Erfinder: NEUHOLD, Stefan, 4654 Lostorf (CH); MUTTER, Simon, 79809 Weilheim Ay (DE)
(74) Vertreter: Rutz, Andrea

(57) **Zusammenfassung**

Ein elektrischer Hochspannungsleiter (17) zur Übertragung von elektrischer Energie bei der Prüfung von Hochspannungsanlagen wird angegeben, welcher eine elektrisch leitfähige Schicht sowie eine Trägerstruktur aufweist. Die elektrisch leitfähige Schicht (20) dient zum Leiten der elektrischen Energie durch den Hochspannungsleiter (17). Die Trägerstruktur (30) dient zum Tragen der elektrisch leitfähigen Schicht (20) und ist hierzu mittels eines Gases in eine schlauchartige Form aufblasbar. Es wird zudem ein Verfahren zur Prüfung einer Hochspannungsanlage unter Verwendung eines derartigen Hochspannungsleiters (17) angegeben.

## Beschreibung

### TECHNISCHES GEBIET

Die vorliegende Erfindung betrifft einen elektrischen Hochspannungsleiter zur Übertragung von elektrischer Energie bei der Prüfung von Hochspannungsanlagen sowie ein Verfahren zur Prüfung von Hochspannungsanlagen.

### STAND DER TECHNIK

Um eine sichere Versorgung mit elektrischer Energie zu garantieren, müssen Produktionsanlagen, wie zum Beispiel Wasserkraftwerke oder Kernkraftwerke, und Verteilsysteme, wie zum Beispiel Hochspannungsleitungen oder Umspannwerke, einen hohen Grad an Zuverlässigkeit besitzen. Im Zusammenhang mit der Zuverlässigkeit von Energieübertragungsanlagen spielt insbesondere die Isolationsfestigkeit bzw. der allgemeine Isolationszustand der eingesetzten Betriebsmittel eine entscheidende Rolle. Zur Überprüfung der Integrität der elektrischen Isolation bei strategisch wichtigen und kostenintensiven Betriebsmitteln, wie zum Beispiel bei Grossgeneratoren und Leistungstransformatoren, Gas-isolierten Hochspannungsschaltanlagen (GIS) und Hochspannungs-Kabelanlagen, werden oft aufwändige Spannungsprüfungen am Aufstellungsort durchgeführt. Eine Vor-Ort-Prüfung einer neuen Hochspannungsanlage ist insbesondere dann sinnvoll, wenn wesentliche Teile der Anlage erst vor Ort erstellt und/oder durch die Montage massgeblich beeinflusst werden können. Dies trifft beispielsweise auf GIS und Kabelanlagen im Hochspannungsbereich zu, da die einzelnen Komponenten oder Baugruppen zwar im Herstellerwerk geprüft werden, jedoch erst am Aufstellungsort zu einer funktionsfähigen Gesamtanlage zusammengebaut werden. Auch grosse Leistungstransformatoren, bei denen nach dem Transport auf der Baustelle noch Montagearbeiten sowie die Ölaufbereitung unter oft schwierigen Bedingungen durchgeführt werden müssen, werden vor der Inbetriebnahme meist einer Hochspannungsprüfung unterzogen. Die Prüfung von Hochspannungsanlagen kann somit insbesondere dazu dienen, den allgemeinen Isolationszustand von energietechnischen Betriebsmitteln sowohl im Neuzustand als auch im betriebsgealterten Zustand zuverlässig zu beurteilen.

Um die Eigenschaften und insbesondere die Isolationsfestigkeit von elektrotechnischen Hochspannungs-Komponenten zu prüfen, müssen hohe Spannungen an diese angelegt werden. Sämtliche Isolatoren der Hochspannungsanlage wirken dabei wie ein praktisch verlustfreier bzw. ein sehr verlustarmer Kondensator. Die Prüfung der elektrischen Isolation kann mit einem Hochspannungstransformator erfolgen, welcher von einer variablen Spannungsquelle gespeist wird. Hochspannungstransformator und Spannungsquelle müssen dabei für die volle, im Wesentlichen kapazitive Blindleistung dimensioniert sein, wodurch ein beträchtlicher technischer Aufwand entsteht. Eine Kompensation dieser Blindleistung ist grundsätzlich möglich, wodurch der gesamte technische Aufwand jedoch nicht wesentlich reduziert wird.

Für grosse Prüflasten und hohe Spannungen mit entsprechend hohen Blindleistungen, wie sie z.B. bei Hochspannungs-Kabel und GIS benötigt werden, wird deshalb in der Regel ein anderer Typ eines Hochspannungs-Prüfsystems eingesetzt. Dieser basiert auf dem Resonanz-Prinzip, wie vorgestellt in Bemasconi F., Zaengl W.S., Vonwiller K.; A new HVseries resonant circuit for dielectric tests; Third international symposium on high voltage engineering; 28 - 31 August 1979; Milan, Italy*,* und ist heute unter dem Begriff Resonanz Test System (RTS) bekannt. Aufgrund des Resonanz-Prinzips kann das Gewicht und die Anschlussleistung des Prüfaufbaus massiv reduziert werden. Hierbei bildet die Kapazität des Prüflings mit der im Prüfkreis eingebauten Induktivität (in Form von Drosseln) einen Schwingkreis. Beim RTS-Typ mit fixer Induktivität und variabler Frequenz der Prüfspannung wird dieser Schwingkreis via einen Erregertransformator durch einen Frequenzumrichter mit seiner Resonanzfrequenz angeregt. Beim RTS-Typ mit fixer Frequenz der Prüfspannung (typischerweise Netzfrequenz; 50 Hz oder 60 Hz) wird durch Anpassung der Induktivität die Resonanzfrequenz auf die fixe Speise-Frequenz eingestellt. Aufgrund der typischerweise hohen Güte des Schwingkreises im Bereich von 100 oder mehr, muss netzseitig zur Speisung der Hochspannungs-Prüfanlage lediglich ca. 1 % der Blindleistung aufgebracht werden.

Um die Aussagekraft der Prüfung einer Hochspannungsanlage zu verbessern, beinhaltet diese oft eine Teilentladungsmessung. Wenn Teilentladungsmessungen vorgesehen sind, muss die Prüfanlage so aufgebaut werden, dass das Entstehen von Teilentladungen bzw. Koronaentladungen an oder in der näheren Umgebung der Prüfanlage möglichst vermieden werden. Dies bedeutet, dass die Abstände zu geerdeten Teilen grösser sein müssen als bei einfachen Spannungsprüfungen, und dass alle spannungsführenden Teile der Prüfanlage und insbesondere die Hochspannungsverbindung zum Freiluft-Endverschluss des Prüflings (Kabel- / GIS-Endverschluss oder andere) keine scharfen Kanten oder Ecken aufweisen dürfen. Sie müssen daher mit abgerundeten Körpern, wie zum Beispiel toroidförmigen Elementen, elektrisch abgeschirmt werden. Um auch im Bereich von Verbindungsleitungen elektrische Feldüberhöhungen zu vermeiden, die potenziell zu Entladungen führen können, werden zur Übertragung der elektrischen Energie statt einfachen Drähten meist metallische, zum Beispiel aus Stahl oder Aluminium hergestellte Rohre verwendet, wodurch ein grösserer Querschnittsradius erreicht wird. Um eine Anpassung der Verbindungsleitung an die vorliegenden Gegebenheiten zu ermöglichen, ist die Verwendung von Teleskoprohren bekannt.

Die zur Hochspannungsprüfung verwendeten Metallrohre weisen als Nachteile jedoch ein erhebliches Gewicht und eine beträchtliche Grösse auf. Die Handhabung, der Transport und die Lagerung derartiger zur Prüfung von Hochspannungsanlagen verwendeten Hochspannungsleiter sind dadurch erschwert. Beispielsweise müssen bei der Installation der Prüfanlage oft temporäre Gerüste aufgestellt werden, um die als Metallrohre ausgebildeten Verbindungsleitungen montieren zu können. Wenn die Verbindungsleitung als Teleskoprohr ausgebildet ist, ist deren Gewicht sogar noch grösser.

Die Idee ist bekannt, Röhren aus Carbonfaser-Verbundmaterial zu verwenden, um das Gewicht von derartigen bei der Hochspannungsprüfung eingesetzten Verbindungsleitungen zu reduzieren. Um eine grössere Stromstärke zu ermöglichen, ist im Inneren der Carbon-Röhre manchmal ein Draht vorgesehen, der zur Leitung des Hauptstroms dient. Diese Lösung ist aufgrund der Carbon-Verbundfaser-Technologie sehr teuer. Auch bekannt ist die Verwendung von spiralarmierten Schläuchen, deren Länge handorgelartig angepasst werden kann. Je nach Länge des Schlauches entstehen jedoch lokale Erhebungen und Vertiefungen auf dessen Aussenfläche, was in Bezug auf die Koronabildung ungünstig ist. Ein weiterer Nachteil dieser spiralarmierten Schläuche ist der sehr geringe Widerstand gegen Biegung entlang der Längsachse. Dies führt beim Einsatz als Hochspannungs-Verbindungs-Leiter zu durchhängenden Strukturen, welche zu Problemen führen in Bezug auf die Einhaltung der elektrischen Schlagweiten zu geerdeten Teilen im Bereich des Prüflings - insbesondere bei Veränderung seiner Position durch Wind. Beim Versuch, den spiralarmierten Schlauch durch Zug an einem der Aufhängepunkte zu spannen, kann es leicht zum Einreissen der folienartigen Verbindung zwischen den Spiralen kommen und damit zur Zerstörung des Schlauches.

Aus der CN 218003459 U ist eine Abschirmvorrichtung für Hochspannungstests bekannt, bei welcher eine Vielzahl von miteinander elektrisch verbundenen Kupferkugeln auf einem Gummiball angeordnet sind. Mittels Aufblasens des Gummiballs ist die Vorrichtung an unterschiedliche Spannungspegel anpassbar.

Die CN 104 698 233 A offenbart eine Abschirmvorrichtung, bei welcher eine mit einem elektrischen Leiter versehene Kontaktfläche mittels Aufblasens an die Oberfläche einer zu prüfenden Hochspannungskomponente anpassbar ist.

Ferner ist in der CN 203086085 U eine mit einem aufblasbaren Schlauch umgebene Hochspannungsleitung offenbart. Der Schlauch dient als Vereisungsschutz, indem Eis und Schnee durch rhythmisches Aufblasen abgeschüttelt werden können.

### DARSTELLUNG DER ERFINDUNG

Es ist eine Aufgabe der vorliegenden Erfindung, einen elektrischen Hochspannungsleiter anzugeben, welcher zur Prüfung von Hochspannungsanlagen einfach installierbar ist. Bevorzugt kann der Hochspannungsleiter zudem einfach transportiert und gelagert werden.

Zur Lösung dieser Aufgabe wird ein elektrischer Hochspannungsleiter vorgeschlagen, wie er in Anspruch 1 angegeben ist. Ausserdem wird in Anspruch 16 ein Verfahren zur Prüfung einer Hochspannungsanlage angegeben. Vorteilhafte Ausführungsformen sind in den abhängigen Ansprüchen angegeben.

Die vorliegende Erfindung stellt also einen elektrischen Hochspannungsleiter zur Übertragung von elektrischer Energie bei der Prüfung von Hochspannungsanlagen zur Verfügung, aufweisend
eine elektrisch leitfähige Schicht zum Leiten der elektrischen Energie durch den Hochspannungsleiter; sowie
eine Trägerstruktur, welche zum Tragen der elektrisch leitfähigen Schicht dient.

Die Trägerstruktur ist mittels eines Gases in eine schlauchartige Form aufblasbar.

Aufgrund der Aufblasbarkeit der Trägerstruktur weist diese also einen kollabierten Zustand auf, in welcher der Hochspannungsleiter einfach transportier- und lagerbar ist, sowie einen aufgeblasenen Zustand, in welchem die Trägerstruktur dem Hochspannungsleiter aufgrund des Gasdrucks eine schlauchartige Form verleiht. Die schlauchartige Form ist besonders gut geeignet zur Verwendung des Hochspannungsleiters bei der Übertragung von elektrischer Energie. Die elektrische Energie kann dabei insbesondere entlang der Hauptlängsrichtung der Trägerstruktur bzw. des Hochspannungsleiters übertragen werden, wobei durch die Schlauchform ein Querschnitt mit vergrössertem Radius gegeben ist, so dass Koronaentladungen vermieden werden können. Allfälligen Oberflächenunebenheiten auf der Aussenseite des Hochspannungsleiters und insbesondere der elektrisch leitfähigen Schicht wird durch den inneren Gasdruck entgegengewirkt. Indem der Hochspannungsleiter während der Hochspannungsprüfung durch den Gasdruck und nicht, wie im Stand der Technik, durch die Eigenstabilität einer Trägerstruktur in Form gehalten wird, kann das Gesamtgewicht des Hochspannungsleiters erheblich reduziert werden. Durch das geringere Gewicht ist der Hochspannungsleiter viel einfacher in der Handhabung und lässt sich besonders einfach installieren. Der Hochspannungsleiter kann insbesondere derart hergestellt werden, dass er vom Monteur ohne weitere Hilfsmittel getragen und installiert werden kann. Insbesondere sind zur Montage und Demontage des Hochspannungsleiters bevorzugt keine Gerüstbauten oder zusätzlichen Kranarbeiten notwendig. Stattdessen kann zur Montage bzw. Demontage an hochgelegenen Stellen beispielsweise eine Hebebühne eingesetzt werden, was für herkömmliche Hochspannungsleiter aufgrund von Gewichts- oder Platz-Einschränkungen bzw. wegen Handhabungsvorschriften normalerweise nicht möglich ist.

Das Aufblasen der Trägerstruktur kann vor oder nach dem Anbringen des Hochspannungsleiters an die elektrotechnischen Komponenten erfolgen. Wenn er vorher aufgeblasen wird, erleichtert sich allenfalls der Aufblasvorgang und ein allfälliges gasdichtes Verschliessen der Trägerstruktur. Wenn der Hochspannungsleiter erst nach der Montage in seine Schlauchform aufgeblasen wird, kann hingegen für den Monteur in vielen Fällen die Montage erleichtert werden.

Die elektrisch leitfähige Schicht dient zum Führen und insbesondere Übertragen eines elektrischen Stromes entlang einer durch die Schlauchform vorgegebene Hauptlängserstreckung des Hochspannungsleiters. Bevorzugt dient ein Metall zum Führen des elektrischen Stromes in der elektrisch leitfähigen Schicht. Beim Metall kann es sich insbesondere um Kupfer, Silber und/oder Nickel handeln. In der Regel erstreckt sich die elektrisch leitfähige Schicht über einen Grossteil der Längserstreckung, bevorzugt über im Wesentlichen die gesamte Längserstreckung des Hochspannungsleiters. Im Querschnitt erstreckt sich die elektrisch leitfähige Schicht bevorzugt umlaufend um eine Längsmittelachse des Hochspannungsleiters. Um Koronaentladungen zu vermeiden, bildet die elektrisch leitfähige Schicht bevorzugt eine insgesamt weitgehend homogene Schicht, welche den Hochspannungsleiter im Umfangsrichtung vorteilhaft vollständig umgibt. Mit einer weitgehend homogenen Schicht ist gemeint, dass der Stromfluss durch die elektrisch leitfähige Schicht für die Zwecke der Hochspannungsprüfung und insbesondere in Bezug auf die Bildung von Teilentladungen als flächig angesehen werden kann und es somit keine Unregelmässigkeiten oder gar Lücken ohne Stromfluss gibt.

Die elektrisch leitfähige Schicht ist bevorzugt dazu ausgebildet, einen Hauptanteil der vom Hochspannungsleiter übertragenen elektrischen Energie zu leiten. Dies bedeutet, dass weitere Anteile der vom Hochspannungsleiter übertragenen elektrischen Energie auch ausserhalb der elektrisch leitfähigen Schicht übertragen werden können. Beispielsweise kann radial innerhalb der Trägerstruktur ein Innenleiter vorgesehen sein, welcher zur Erhöhung der vom Hochspannungsleiter übertragbaren elektrischen Energie dient. Bevorzugt ist die elektrisch leitfähige Schicht aber dazu ausgebildet, im Vergleich zum Innenleiter einen grösseren Anteil an elektrischer Energie zu übertragen. In anderen Ausführungsformen kann die elektrisch leitfähige Schicht aber auch dazu ausgebildet sein, einen geringeren Anteil an elektrischer Energie zu übertragen als beispielsweise ein Innenleiter. Die elektrisch leitfähige Schicht kann in diesem Fall hauptsächlich zur Abschirmung und Vermeidung von Teilentladungen dienen, während der Grossteil des Stromes durch den Innenleiter übertragen wird. Beim Innenleiter kann es sich beispielsweise um eine Litze, insbesondere eine Flachlitze, handeln. In einer insbesondere bevorzugten Ausführungsform ist die elektrisch leitfähige Schicht jedoch dazu ausgebildet, die gesamte vom Hochspannungsleiter übertragene elektrische Energie zu leiten.

Eine alternative oder zusätzliche Möglichkeit zum Erhöhen der durch den Hochspannungsleiter leitbaren elektrischen Energie ist das Vorsehen von einem oder mehreren zusätzlichen elektrisch leitfähigen Schichten beispielsweise zwischen der Trägerstruktur und der elektrisch leitfähigen Schicht und/oder radial innerhalb der Trägerstruktur. Zur Vermeidung von Reibung können zwischen den mehreren elektrisch leitfähigen Schichten Zwischenschichten vorgesehen werden, die aus einem flexiblen, reibungsvermindernden Material, insbesondere aus einem gummiartigen Material, oder einem Material mit sehr geringem Reibungskoeffizienten, wie zum Beispiel Polytetrafluorethylen (PTFE), hergestellt sind.

Als Trägerstruktur wird in der Regel diejenige Struktur angesehen, welche während der Hochspannungsprüfung als hauptsächliche Struktur zum Halten und/oder zur Stützung der elektrisch leitfähigen Schicht beiträgt.

Die elektrisch leitfähige Schicht ist bevorzugt an der radialen Aussenseite der Trägerstruktur angeordnet. Beim Aufblasen und im aufgeblasenen Zustand des Hochspannungsleiters wird sie dadurch von der Trägerstruktur radial nach aussen gedrückt und in Form gehalten. Der Hochspannungsleiter ist dadurch besonders einfach herstellbar. Je nach Ausführungsform wäre es aber auch denkbar, dass die elektrisch leitfähige Schicht an der radialen Innenseite der Trägerstruktur oder sogar innerhalb der Trägerstruktur angeordnet ist. In Bezug auf den letztgenannten Fall wäre es beispielsweise denkbar, dass die elektrisch leitfähige Schicht in der Trägerstruktur eingebettet ist.

Bei der Trägerstruktur handelt es sich bevorzugt um eine weitgehend gasdichte Struktur. Mit weitgehend gasdicht ist gemeint, dass die Trägerstruktur dazu ausgebildet ist, den notwendigen Gasdruck über die Dauer der Hochspannungsprüfung aufrechtzuhalten. Bei dem zum Aufblasen der Trägerstruktur verwendeten Gas handelt es sich bevorzugt um Luft. Die Verwendung von anderen Gasen als Luft ist denkbar. Insbesondere kann es sich bei dem zum Aufblasen der Trägerstruktur verwendeten Gas auch um ein gegenüber Luft leichteres Gas, wie zum Beispiel Helium, handeln. Auf diese Weise kann das Gewicht des Hochspannungsleiters weiter reduziert werden.

Als Hochspannung werden im Allgemeinen Spannungen angesehen, deren Werte 1'000 Volt Wechselspannung oder 1'500 Volt Gleichspannung überschreiten. Der Hochspannungsleiter ist daher vorzugsweise zur Übertragung von Wechselspannungen von mehr als 1000 V und/oder zur Übertragung von Gleichspannungen von mehr als 1500 V geeignet. Insbesondere bevorzugt ist der Hochspannungsleiter jedoch zur Übertragung von Wechselspannungen von mehr als 36'000 V und/oder zur Übertragung von Gleichspannungen von mehr als 51'000 Volt geeignet. Bei derart hohen Spannungen wirken sich die mit dem erfindungsgemässen Hochspannungsleiter erreichten Vorteile besonders aus.

Bei den elektrotechnischen Komponenten, die mittels des Hochspannungsleiters elektrisch miteinander verbunden werden, kann es sich insbesondere um Einspeisedurchführungen, Messteiler und/oder Drosseln handeln. Im Allgemeinen dient der Hochspannungsleiter bevorzugt zur Einspeisung von elektrischer Energie bei Hochspannungsprüfungen. Insbesondere bevorzugt ist der Hochspannungsleiter für den Einsatz in einem Resonanzkreis ausgebildet.

Bei einem Schlauch handelt es sich um einen länglichen Hohlkörper. Der Hohlkörper ist dabei bevorzugt zylindrisch. Je nach Ausführungsform kann es sich aber zum Beispiel auch um einen gebogenen, gewellten oder andersartig geformten länglichen Hohlkörper handeln.

Im Querschnitt weist die Trägerstruktur, bevorzugt der Hochspannungsleiter als Ganzes, im aufgeblasenen Zustand entlang seiner Hauptlängsrichtung einen konstanten Querschnitt auf, sowohl in Bezug auf Grösse als auch auf Form. In gewissen Ausführungsformen und je nach Anwendung ist es aber auch denkbar, dass der Querschnitt entlang der Hauptlängsrichtung variabel ist, das heisst dass die Trägerstruktur bzw. der Hochspannungsleiter zum Beispiel lokale Verdickungen und/oder lokale Verengungen aufweisen kann.

In gewissen Ausführungsformen kann der Hochspannungsleiter im aufgeblasenen Zustand noch eine gewisse Flexibilität aufweisen, das heisst, dass er über seine Gesamtlänge von einer erwachsenen Person mittels reiner Muskelkraft noch deutlich erkennbar ein Stück weit gebogen werden kann. Bevorzugt ist eine derartige Flexibilität im aufgeblasenen Zustand des Trägerkörpers jedoch nicht vorhanden, das heisst die Form des Hochspannungsleiters ist im aufgeblasenen Zustand weitgehend unveränderlich.

Bevorzugt erstreckt sich der Trägerkörper, vorteilhaft der Hochspannungsleiter als Ganzes, im aufgeblasenen Zustand geradlinig entlang seiner Hauptlängsrichtung. Der Prüfaufbau ist dadurch einfacher plan- und berechenbar. In gewissen Ausführungsformen kann der Trägerkörper, und je nachdem der Hochspannungsleiter als Ganzes, im aufgeblasenen Zustand auch eine Bogenform oder eine beliebige andere Gestalt bilden. Der Hochspannungsleiter kann dadurch an spezielle Prüfgegebenheiten angepasst sein.

Im aufgeblasenen Zustand bildet die elektrisch leitfähige Schicht, vorteilhaft auch die Trägerschicht, bevorzugt einen kreisrunden Querschnitt. Ein kreisrunder Querschnitt ist in der Regel optimal zur Vermeidung von Entladung. Je nach Ausführungsform und Anwendung sind aber auch andere Querschnitte, wie beispielsweise ein ovaler Querschnitt, denkbar. Ein von einer kreisrunden Form abweichender Querschnitt kann beispielsweise mittels einer in oder an der Trägerstruktur vorgesehenen kraftaufnehmenden Struktur erreicht werden und/oder mittels eines Trägermaterials, das entlang der Umfangsrichtung des Hochspannungsleiters unterschiedliche Biegbarkeiten aufweist.

Zu Lagerungs- und/oder Transportzwecken ist der Hochspannungsleiter entlang seiner Hauptlängserstreckung bevorzugt zumindest teilweise, insbesondere bevorzugt sogar ganz, aufrollbar. Vorteilhaft ist der Hochspannungsleiter dabei zerstörungsfrei in sich selbst aufrollbar, das heisst es ist keine Spule oder Wickelkern notwendig, um den Hochspannungsleiter darum herum aufzurollen. Durch das Aufrollen kann der Platzbedarf des Hochspannungsleiters im Hinblick auf Transport- und/oder Lagerungszwecke besonders effizient reduziert werden. Durch das Kollabieren und anschliessende Aufrollen kann das Volumen des Hochspannungsleiters bevorzugt um ein ganzzahliges Vielfaches oder mehr reduziert werden.

Bei einer insbesondere bevorzugten Ausführungsform weist die elektrisch leitfähige Schicht ein Metallgewebe auf. Der Hochspannungsleiter weist insbesondere bevorzugt ein mit einem Metallgewebe überzogenen Folienschlauch auf. Der Folienschlauch bildet dann die Trägerstruktur. Ein Metallgewebe ist einerseits einfach herstellbar und weist andererseits eine gute Flexibilität auf. Die elektrisch leitfähige Schicht kann beispielsweise zum Schutz ein Verbundmaterial aufweisen, in welches das Metallgewebe eingebettet ist. Beim Metallgewebe kann es sich insbesondere um ein metallisiertes Kunststoffgewebe handeln. Ein metallisiertes Kunststoffgewebe ist ein Gewebe, das von z.B. metallbeschichteten oder metalldurchsetzten Kunststofffäden gebildet wird. Das Kunststoffgewebe kann insbesondere ein Polyestergewebe sein. Bei dem zur Metallisierung des Gewebes dienenden Metalls kann es sich insbesondere um Kupfer, Silber, Nickel oder einer Kombination davon handeln. Als insbesondere geeignet im Hinblick auf Festigkeit, Stromleitung und Herstellungskosten hat sich eine elektrisch leitfähige Schicht in Form einer zuerst verkupferten und anschliessend versilberten Polyestergewebe erwiesen.

Der Hochspannungsleiter weist bevorzugt eine Länge von mehr als 2m, bevorzugter von mehr als 4m, am bevorzugtesten von mehr als 6m auf. Der Durchmesser des Hochspannungsleiters und insbesondere der elektrisch leitfähigen Schicht beträgt bevorzugt 10cm oder mehr, bevorzugter 15cm oder mehr und am bevorzugtesten 20cm oder mehr. Bei Versuchen konnte ein erfindungsgemässer Hochspannungsleiter von 7m Länge und mit 20cm Durchmesser hergestellt werden, der insgesamt lediglich 1.5kg wiegt, was im Vergleich zu einem üblicherweise verwendeten Aluminiumrohr mit diesen Massen mehr als zehn Mal leichter ist. Der Hochspannungsleiter, insbesondere mit dieser Dimensionierung, weist bevorzugt eine Stromübertragungs-Kapazität von zumindest 0.1 A, bevorzugter von zumindest 1 A und am bevorzugtesten von zumindest 10 A auf. Die Stromübertragungs-Kapazität bezieht sich auf diejenige Menge an elektrischem Strom, welche über den Hochspannungsleiter noch problemlos übertragen werden kann. Der Spannungsabfall entlang der Längserstreckung des Hochspannungsleiters beträgt dabei bevorzugt weniger als 1 V/m, bevorzugter weniger als 0.1 V/m.

Im aufgeblasenen Zustand liegt im Inneren der Trägerstruktur gegenüber der Umgebung ausserhalb des Hochspannungsleiters bevorzugt ein Überdruck vor, der mindestens 0.03 bar, bevorzugter mindestens 0.05 bar, noch bevorzugter mindestens 0.3 bar, und am bevorzugtesten mindestens 0.8 bar, beträgt. Es konnte festgestellt werden, dass mit diesen Überdruck-Werten ein Hochspannungsleiter mit ausreichender Eigenstabilität erreicht werden kann. In Bezug auf die Maximalwerte ist der Hochspannungsleiter bevorzugt dazu ausgebildet, dass im aufgeblasenen Zustand im Inneren der Trägerstruktur gegenüber der Umgebung ausserhalb des Hochspannungsleiters ein Überdruck herrscht, der bei mindestens 0.8 bar, bevorzugter bei mindestens 1 bar, noch bevorzugter bei mindestens 1.2 bar, und am bevorzugtesten bei mindestens 1.4 bar liegt. Ein Hochspannungsleiter, der auf diese Überdruck-Werte aufgeblasen werden kann, weist eine besonders hohe und für die Zwecke der Hochspannungsprüfung ausreichende Eigenstabilität auf. Vorzugsweise weist die Trägerstruktur hierzu eine kraftaufnehmende Struktur auf, die entsprechend belastbar ist.

Bevorzugt ist die Form des Hochspannungsleiters im aufgeblasenen Zustand durch die elektrisch leitfähige Schicht definiert. Dies bedeutet in der Regel, dass die elektrisch leitfähige Schicht eine im Vergleich zur Trägerstruktur geringere Dehnbarkeit aufweist. Beim Aufblasen wird die Trägerstruktur dadurch bevorzugt so weit gedehnt, bis eine weitere Ausdehnung in radialer Richtung durch die elektrisch leitfähige Schicht verunmöglicht wird. Der Radius des Hochspannungsleiters im aufgeblasenen Zustand wird dann also durch die elektrisch leitfähige Schicht bestimmt. Indem der Radius im aufgeblasenen Zustand des Hochspannungsleiters klar definiert und vorbestimmt ist, erleichtert sich die Planung und Berechnung des Prüfaufbaus. Je nach Anwendung wäre es bei anderen Ausführungsformen aber auch denkbar, nicht nur die Trägerstruktur, sondern auch die elektrisch leitfähige Schicht dehnbar auszugestalten, um eine bedarfsweise Anpassung des Radius' des Hochspannungsleiters zu ermöglichen.

Je nach Ausführungsform und Anwendung könnte es aber auch von Vorteil sein, wenn die Form des Hochspannungsleiters im aufgeblasenen Zustand durch die Trägerstruktur definiert ist. In diesem Fall weist also die Trägerstruktur im Vergleich zur elektrisch leitfähigen Schicht eine geringere Dehnbarkeit auf. Beim Aufblasen wird eine weitere Ausdehnung in radialer Richtung also durch die Trägerstruktur verunmöglicht. Die elektrisch leitfähige Schicht kann dann eine gewisse Dehnbarkeit aufweisen oder gerade an diesen Radius angepasst sein. Der Radius des Hochspannungsleiters im aufgeblasenen Zustand wird in diesem Fall also durch die Trägerstruktur bestimmt.

Bevorzugt bildet die Trägerstruktur das Hauptgewicht des Hochspannungsleiters. Je nachdem kann das Hauptgewicht des Hochspannungsleiters aber auch durch die elektrisch leitfähige Schicht oder durch eine andere Komponente gebildet werden.

Bei einer besonders einfach herstellbaren Ausführungsform liegen die elektrisch leitfähige Schicht und die Trägerstruktur lose aufeinander. Vorteilhaft sind sie dabei nicht miteinander verbunden. Um den Transport und die Lagerung zu erleichtern, aber auch zu Reinigungszwecken, kann die elektrisch leitfähige Schicht insbesondere von der Trägerstruktur entfernbar sein. Auch denkbar sind aber auch Ausführungsformen, bei denen die elektrisch leitfähige Schicht und die Trägerstruktur zum Beispiel punktuell an mehreren Stellen oder grossflächig miteinander verbunden sind, und bei denen je nachdem eine Entfernung der elektrisch leitfähigen Schicht und der Trägerstruktur voneinander nicht möglich ist.

Zur Befestigung der elektrisch leitfähigen Schicht an der Trägerstruktur mittels eines Schnür- oder Halteseils können an einem oder beiden Kopfenden der elektrisch leitfähigen Schicht Ringösen und/oder Laschen vorgesehen sein.

Die elektrisch leitfähige Schicht kann eine Naht aufweisen, welche sich entlang der Hauptlängserstreckung des Hochspannungsleiters erstreckt und zum Zusammenhalten der elektrisch leitfähigen Schicht in Umfangsrichtung dient. Diese Naht kann z.B. mit Faden genäht, mit Klebstoff geklebt und/oder mit einem geeigneten Verfahren geschweisst sein. Um Kanten und nach aussen vorstehende Ausfransungen im Bereich der Naht zu vermeiden, ist die Naht bevorzugt derart ausgebildet, dass die beiden mit der Naht verbundenen Seitenränder der elektrisch leitfähigen Schicht nach innen gelegt sind.

Anstelle einer Naht können an den sich in Längsrichtung des Hochspannungsleiters erstreckenden Seitenrändern der elektrisch leitfähigen Schicht auch Ringösen und/oder Laschen vorgesehen sein, welche zum Zusammenhalten der elektrisch leitfähigen Schicht in Umfangsrichtung mittels eines Schnürseils dienen.

Die Trägerstruktur kann zum Beispiel aus einer Thermoplast-Folie oder einer Elastomer-Folie hergestellt sein. Bevorzugt ist die Trägerstruktur aber aus einem Kunststoff mit einer Gewebeeinlage hergestellt. Die Gewebeeinlage, welche in einem Matrixmaterial, wie zum Beispiel einem Polymermaterial, eingebettet sein kann, dient vorteilhaft zur Verstärkung der Festigkeit der Trägerstruktur. Bevorzugt handelt es sich beim Matrixmaterial um einen Thermoplast oder ein Elastomer.

In einer insbesondere bevorzugten Ausführungsform ist die Trägerstruktur im aufgeblasenen Zustand gasdicht verschliessbar. Die Trägerstruktur und somit der Hochspannungsleiter als Ganzes kann somit nach dem Aufblasen seine für die Hochspannungsprüfung vorgesehene schlauchartige Form einnehmen und durch das gasdichte Verschliessen der Trägerstruktur beibehalten. Das Verschliessen der Trägerstruktur kann insbesondere selbsttätig durch ein Ventil erfolgen. Bei anderen Ausführungsformen wäre es auch denkbar, dass die Trägerstruktur nicht gasdicht verschliessbar ist und der Gasdruck während der Hochspannungsprüfung mit Hilfe eines permanent betriebenen Druckgaskompressors aufrechterhalten wird.

Um den Hochspannungsleiter an die örtlichen Gegebenheiten anzupassen, ist dessen Gesamtlänge im aufgeblasenen Zustand bevorzugt anpassbar. Die Anpassbarkeit der Gesamtlänge des Hochspannungsleiters kann insbesondere dadurch erreicht werden, dass die Trägerstruktur und bevorzugt die elektrisch leitfähige Schicht entlang ihrer Hauptlängserstreckungen teilweise, d.h. nach Bedarf, aufgerollt werden. Das Aufrollen kann dabei von einem oder von beiden Kopfenden her erfolgen.

Um zusätzliche elektrische Energie übertragen zu können, kann der Hochspannungsleiter ausserdem einen im Inneren der Trägerstruktur angeordneten Innenleiter aufweisen. Ausführungsformen, bei denen kein Innenleiter vorhanden ist, haben demgegenüber den Vorteil, dass sie einfacher herstellbar sind, insbesondere weil die bevorzugt gasdichte Durchführung des Innenleiters durch die Trägerstruktur dann wegfällt.

Die vorliegende Erfindung bezieht sich ausserdem auf ein Verfahren zur Prüfung einer Hochspannungsanlage, wobei zwei elektrotechnische Komponenten mittels eines elektrischen Hochspannungsleiters, insbesondere mittels eines Hochspannungsleiters wie oben angegeben, miteinander verbunden werden, der eine elektrisch leitfähige Schicht aufweist, welche zum Übertragen der elektrischen Energie zwischen den beiden elektrotechnischen Komponenten ausgebildet ist, sowie eine Trägerstruktur hat, welche zum Tragen der elektrisch leitfähigen Schicht dient. Die Trägerstruktur wird dabei mittels eines Gases in eine schlauchartige Form aufgeblasen.

Das Verbinden der beiden elektrotechnischen Komponenten mittels des Hochspannungsleiter und das Aufblasen kann in beliebiger Reihenfolge durchgeführt werden. Der Hochspannungsleiter kann also vor, während und/oder nach dem Verbinden mit den elektrotechnischen Komponenten aufgeblasen werden. Bei den elektrotechnischen Komponenten, die mittels des Hochspannungsleiters elektrisch miteinander verbunden werden, kann es sich insbesondere um Einspeisedurchführungen, Messteiler und/oder Drosseln handeln.

Das Aufblasen der Trägerstruktur kann zum Beispiel mittels einer Pumpe von Hand oder mittels einer motorisierten Gaspumpe, d.h. eines Gaskompressors, insbesondere eines Druckluftkompressors, erfolgen.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine schematische Ansicht von der Seite her eines Prüfaufbaus zum Prüfen einer Hochspannungsanlage unter Verwendung von erfindungsgemässen Hochspannungsleitern;
- Fig. 2: eine schematische Querschnittsansicht eines erfindungsgemässen Hochspannungsleiters im aufgeblasenen Zustand;
- Fig. 3: eine schematische Querschnittsansicht des Hochspannungsleiters der Fig. 2 im kollabierten Zustand;
- Fig. 4a: eine Querschnittsansicht der Trägerstruktur eines schematisch dargestellten erfindungsgemässen Hochspannungsleiters;
- Fig. 4b: eine Längsschnittansicht der Trägerstruktur der Fig. 4a;
- Fig. 5a: eine perspektivische Ansicht einer schematisch dargestellten elektrisch leitfähigen Schicht eines erfindungsgemässen Hochspannungsleiters;
- Fig. 5b: eine Querschnittsansicht der elektrisch leitfähigen Schicht der Fig. 5a;
- Fig. 5c: eine Längsschnittansicht der elektrisch leitfähigen Schicht der Fig. 5a;
- Fig. 5d: eine vergrössert dargestellte Querschnitts-Teilansicht der elektrisch leitfähigen Schicht der Fig. 5a, mit einer anderen Variante einer Längsnaht;
- Fig. 6a: eine perspektivische Teilansicht eines schematisch dargestellten Hochspannungsleiters gemäss einer bevorzugten Ausführungsform;
- Fig. 6b: eine Draufsicht auf ein Kopfende des Hochspannungsleiters der Fig. 6a;
- Fig. 6c: eine perspektivische, schematische Teilansicht des Schichtaufbaus des Hochspannungsleiters der Fig. 6a;
- Fig. 7: eine Draufsicht auf ein Kopfende eines erfindungsgemässen Hochspannungsleiters;
- Fig. 8a: eine perspektivische Teilansicht eines schematisch dargestellten Hochspannungsleiters gemäss einer anderen bevorzugten Ausführungsform;
- Fig. 8b: eine Schnittansicht durch eine Befestigungslasche am Kopfende des Hochspannungsleiters der Fig. 8a;
- Fig. 8c: eine perspektivische Detailansicht einer Befestigungslasche am Kopfende des Hochspannungsleiters der Fig. 8a;
- Fig. 8d: eine perspektivische Teilansicht des Kopfendes des Hochspannungsleiters der Fig. 8a;
- Fig. 9: ein schematischer Längsschnitt durch zwei miteinander verbundene, erfindungsgemässe Hochspannungsleiter;
- Fig. 10: einen Längsschnitt durch einen schematisch dargestellten, erfindungsgemässen Hochspannungsleiter mit Luftventilen an beiden Kopfenden;
- Fig. 11a: einen Längsschnitt durch einen schematisch dargestellten, längenanpassbaren Hochspannungsleiter gemäss einer bevorzugten erfindungsgemässen Ausführungsform;
- Fig. 11b: einen Längsschnitt in einer zur Fig. 11a rechtwinklig stehenden Ebene des Hochspannungsleiters der Fig. 11a;
- Fig. 12: eine perspektivische Teilansicht eines gebogenen erfindungsgemässen Hochspannungsleiters gemäss einer weiteren Ausführungsform;
- Fig. 13a: eine schematische Ansicht der in Segmente aufgeteilten elektrisch leitfähigen Schicht eines gebogenen erfindungsgemässen Hochspannungsleiters gemäss einer nochmals weiteren Ausführungsform;
- Fig. 13b: eine perspektivische Teilansicht eines gebogenen erfindungsgemässen Hochspannungsleiters mit der durch die miteinander verbundenen Segmente der Fig. 13a gebildeten elektrisch leitfähigen Schicht;
- Fig. 14a: eine schematische Ansicht von der Seite her eines teilweise dargestellten weiteren Prüfaufbaus zum Prüfen einer Hochspannungsanlage unter Verwendung von erfindungsgemässen Hochspannungsleitern sowie einer Eckverbindung;
- Fig. 14b: eine Querschnittsansicht von der Seite der Eckverbindung des Prüfaufbaus der Fig. 14a; sowie
- Fig. 14c: eine Querschnittsansicht von oben der Eckverbindung des Prüfaufbaus der Fig. 14a.

### BESCHREIBUNG BEVORZUGTER AUSFÜHRUNGSFORMEN

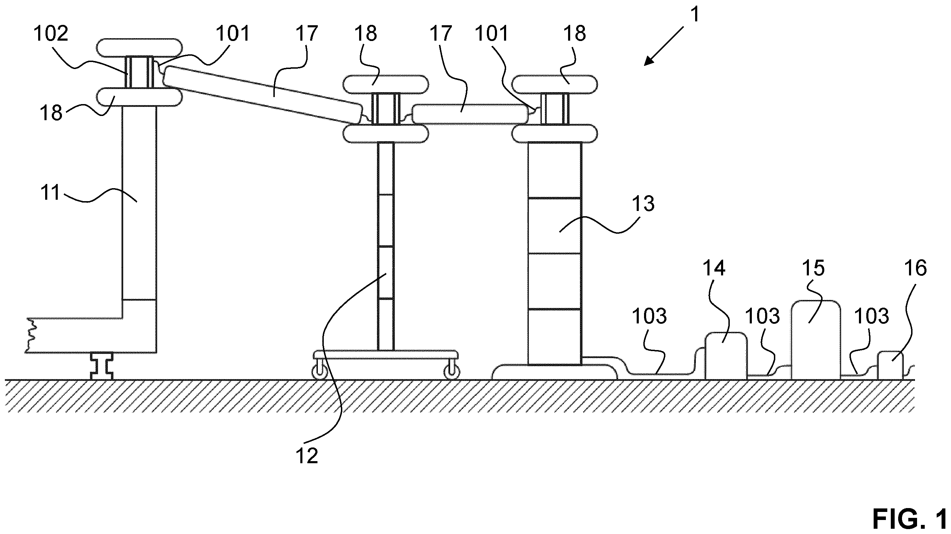

In den Figuren 1 bis 14c sind erfindungsgemässe Hochspannungsleiter sowie Teile davon in verschiedenen bevorzugten Ausführungsformen gezeigt. Gleich oder ähnlich wirkende Elemente von verschiedenen Ausführungsformen sind jeweils mit demselben Bezugszeichen versehen.

Die Figur 1 zeigt schematisch den Hochspannungsprüfaufbau 1 zum Prüfen einer elektrischen Hochspannungsanlage. Die Hochspannungsprüfung wird bevorzugt basierend auf einem Resonanzkreis durchgeführt und wird vorteilhaft von Teilentladungsmessungen begleitet. Der Hochspannungsprüfaufbau 1, welcher dem Fachmann in Bezug auf seine Komponenten und Funktionsweise grundsätzlich bekannt ist und deshalb keiner detaillierten Erläuterungen bedarf, weist eine Einspeisedurchführung 11 der zu prüfenden Hochspannungsanlage, einen mobilen Messteiler 12, Drosseln 13, einen Erregungstransformator 14, einen Umrichter 15 sowie vorzugsweise einen Isoliertransformator 16 auf.

Die Drosseln 13, der Erregungstransformator 14, der Umrichter 15 und der Isoliertransformator 16 sind wie in der Figur 1 gezeigt mittels herkömmlicher elektrischer Verbindungskabel 103 miteinander verbunden. Die einzelnen Verbindungskabel 103 können je nach Verwendungszweck und Einsatzart gleich oder unterschiedlich ausgebildet und dimensioniert sein.

Die Einspeisedurchführung 11 und der Messteiler 12 einerseits sowie der Messteiler 12 und die Drosseln 13 andererseits sind jeweils mittels eines erfindungsgemässen Hochspannungsleiters 17 miteinander verbunden. Die Hochspannungsleiter 17 wiederum sind jeweils via ein herkömmliches elektrisches Verbindungskabel 101 an einem oberen Endbereich der Einspeisedurchführung 11, des Messteiles 12 und der Drosseln 13 angeschlossen. Der Anschluss der Hochspannungsleiter 17 an der Einspeisedurchführung 11, dem Messteiler 12 bzw. den Drosseln 13 erfolgt dabei jeweils in einem von zwei Abschirmtoroiden 18 abgeschirmten Bereich. Die Abschirmtoroide 18 werden jeweils durch Distanzhalter 102 auseinandergehalten. Anstelle von Abschirmtoroiden 18 sind auch Abschirmelemente mit anderen geometrischen Formen, wie zum Beispiel Kugeln, denkbar. Die elektrischen Verbindungskabel 101 erstrecken sich dadurch alle in einem jeweils abgeschirmten Bereich.

Die beiden erfindungsgemäss ausgebildeten Hochspannungsleiter 17 dienen zur Übertragung von elektrischer Energie von den Drosseln 13 zum Messteiler 12 bzw. vom Messteiler 12 zur Einspeisedurchführung 11. Die Flussrichtung des elektrischen Stromes kann aufgrund des Funktionsprinzips der Prüfanlage bzw. abhängig von der Prüfsituation von den Drosseln 13 zur Einspeisedurchführung 11 sowie auch in umgekehrter Richtung sein. Um Teilentladungen zu vermeiden, ist sichergestellt, dass die Hochspannungsleiter 17 entlang ihrer jeweils gesamten Längserstreckung in ausreichenden Abstand über dem Boden angeordnet sind. Ebenfalls zur Vermeidung von Teilentladungen weisen die Hochspannungsleiter 17 zudem einen jeweils ausreichend grossen elektrisch wirksamen Querschnittsradius sowie eine möglichst glatte Oberfläche auf.

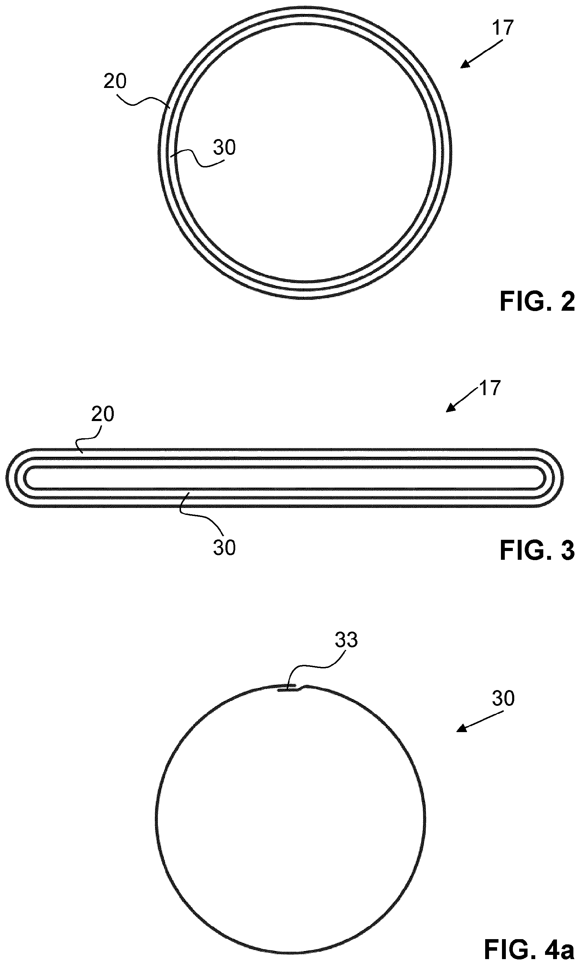

Der grundsätzliche Aufbau des erfindungsgemässen Hochspannungsleiters 17 ist in den Figuren 2 und 3 ersichtlich. Wie in der Figur 2 gut erkennbar ist, weist der Hochspannungsleiter 17 im aufgeblasenen Zustand, das heisst in demjenigen Zustand, in dem die eigentliche Hochspannungsprüfung durchgeführt wird, eine insgesamt schlauchartige Form mit einem kreisrunden Querschnitt auf. Der Hochspannungsleiter 17 weist eine elektrisch leitfähige Schicht 20 sowie eine Trägerstruktur 30 auf. Die elektrisch leitfähige Schicht 20 bildet die bei der Hochspannungsprüfung elektrisch wirksame Komponente des Hochspannungsleiters 17. Sie bildet bei der vorliegenden Ausführungsform die Aussenfläche des Hochspannungsleiters 17. Bei der Hochspannungsprüfung wird durch die elektrisch leitfähige Schicht 20 hindurch elektrische Energie, insbesondere elektrische Hochspannungsenergie, übertragen.

Die Trägerstruktur 30 ist radial innerhalb der elektrisch leitfähigen Schicht 20 angeordnet. Durch den im Inneren des Hochspannungsleiters 17 herrschenden Gasdruck wird die aus einem flexiblen Material hergestellte Trägerstruktur im aufgeblasenen Zustand radial nach aussen gegen die elektrisch leitfähige Schicht 20 gedrückt. Die Trägerstruktur 30 ist somit aufblasbar und hierzu aus einer gasdichten Folie oder Membran hergestellt. Im aufgeblasenen Zustand dient sie zum Tragen der elektrisch leitfähigen Schicht 20.

Bevorzugt weist die Trägerstruktur 30 eine gewisse Dehnbarkeit auf, welche die Dehnbarkeit der elektrisch leitfähigen Schicht 20 übersteigt. Beim Aufblasen, das heisst beim Einleiten eines Gases wie insbesondere Luft in den von der Trägerstruktur 30 umschlossenen Innenraum, dehnt sich die Trägerstruktur 30 dadurch aus, bis sie umlaufend an der elektrisch leitfähigen Schicht 30 anliegt und eine weitere Ausdehnung durch diese verhindert wird. Die im aufgeblasenen Zustand durch den inneren Gasdruck entstandene schlauchartige Form des Hochspannungsleiters 17 wird somit durch die elektrisch leitfähige Schicht 20 hinsichtlich Gestalt und Dimensionierung definiert.

Für den Transport und die Lagerung kann das Gas aus dem Innenraum des Hochspannungsleiters 17 entlassen werden, so dass der Hochspannungsleiter 17 kollabiert, wie es in der Figur 3 gezeigt ist. Der Hochspannungsleiter 17 nimmt dadurch ein erheblich kleineres Volumen ein und ist zudem falt- oder aufrollbar.

Gemäss einer bevorzugten Ausführungsform können die elektrisch leitfähige Schicht 20 und die Trägerstruktur 30 lose aufeinander liegen, d.h. sie müssen nicht miteinander verbunden sein. Es ist aber auch denkbar, dass die elektrisch leitfähige Schicht 20 und die Trägerstruktur 30 in anderen Ausführungsformen punktuell an gewissen Stellen oder vollflächig miteinander verbunden sind.

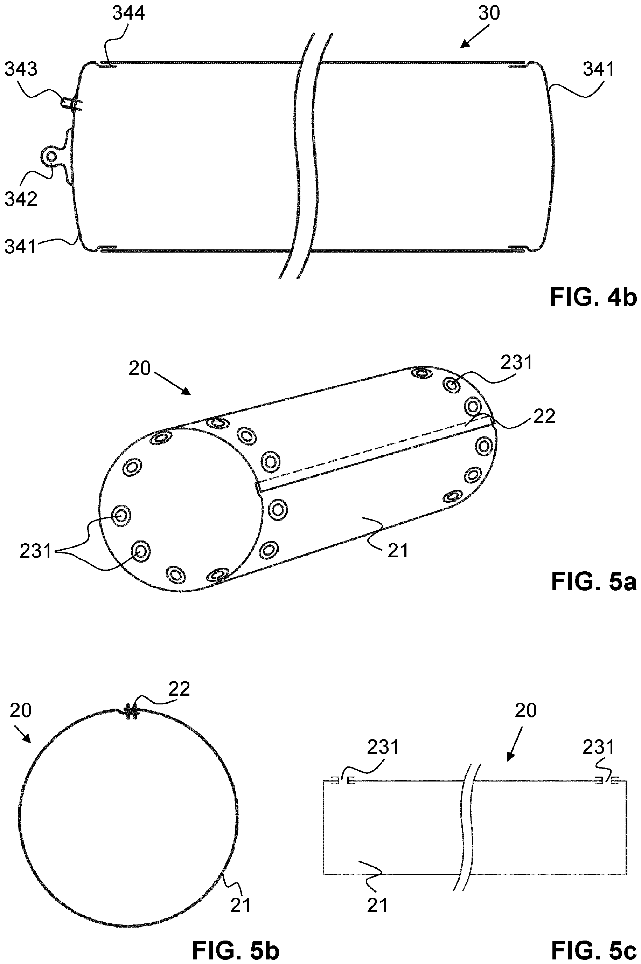

Eine bevorzugte Ausführungsform der Trägerstruktur 30 ist in den Figuren 4a und 4b gezeigt. Die Trägerstruktur 30, welche an sich aus einer rechteckigen Folie oder Membran als Hauptkomponente hergestellt ist, weist eine Längsnaht 33 auf, entlang welcher zwei Seitenränder der Folie bzw. Membran gasdicht miteinander verbunden sind. Je nach Ausführungsform kann die Längsnaht 33 beispielsweise genäht, geklebt und/oder geschweisst sein. Mit einer genähten Längsnaht 33 ist eine besonders hohe Festigkeit erreichbar. Falls die Längsnaht 33 aber genäht ist, ist sie, um eine ausreichende Gasdichtigkeit zu erreichen, bevorzugt ausserdem geklebt oder geschweisst. Die Folie bzw.

Membran bildet somit einen Schlauch, welcher in eine insgesamt hohlzylindrische Form aufblasbar ist. Ausführungsformen ohne eine Längsnaht 33 sind ebenfalls denkbar, beispielsweise bei einer Herstellung der Trägerstruktur 30 mittels Extrusion in die Form eines Schlauches.

Wie aus der Figur 4b ersichtlich ist, weist die Trägerstruktur 30 an den Kopfenden als weitere gasdichte Naht eine Verbindungsstelle 344 auf, welche sich dort jeweils in Umfangsrichtung erstreckt. An der Verbindungsstelle 344 ist jeweils ein Kopfteil 341 am Schlauchende angebracht, das durch die erwähnte Folie bzw. Membran gebildet wird. Das Kopfteil 341 dient jeweils zum Verschliessen und Abdichten des von der Trägerstruktur 30 gebildeten Innenraums an den Schlauchenden. Auch die Verbindungsstelle 344 kann beispielsweise genäht, geklebt und/oder verschweisst sein. Mittels Vernähen der Verbindungsstelle 344 kann eine besonders hohe Festigkeit erreicht werden. Falls die Verbindungsstelle 344 aber genäht ist, ist sie, um eine ausreichende Gasdichtigkeit zu erreichen, bevorzugt ausserdem geklebt oder geschweisst.

In einem der Kopfteile 341 ist ein Luftventil 343 vorgesehen, über welches Druckluft in das Innere der Trägerstruktur 30 eingeleitet werden kann, um diese aufzublasen. Im aufgeblasenen Zustand dichtet das Luftventil 343 den Innenraum der Trägerstruktur 30 selbsttätig nach aussen hin ab. Nach erfolgter Hochspannungsprüfung kann das Luftventil 343 geöffnet werden, um das Gas aus der Trägerstruktur 30 nach aussen hin abzulassen und den Hochspannungsleiter 17 zwecks Transport und Lagerung zu kollabieren.

An den Kopfteilen 341 oder, wie hier, an zumindest einem davon kann ein Haltering 342 angebracht sein, welcher zur mechanischen Befestigung der Trägerstruktur 30 bzw. des ganzen Hochspannungsleiters 17 an einer jeweiligen elektrotechnischen Komponente dient. Der Haltering 342 kann auch zum Tragen oder Aufhängen des Hochspannungsleiters 17 im kollabierten Zustand dienen.

In den Figuren 5a bis 5c ist in verschiedenen Ansichten die elektrisch leitfähige Schicht 20 gezeigt. Die elektrisch leitfähige Schicht 20, welche zum Leiten der elektrischen Energie bevorzugt zumindest teilweise aus einem Metall, insbesondere aus einem Metallgewebe 21, hergestellt ist, wird aus einer flexiblen, an sich rechteckigen Lage hergestellt, von welcher zwei Seitenränder, wie in den Figuren 5a und 5b gezeigt, mittels einer Längsnaht 22 miteinander verbunden sind. Die elektrisch leitfähige Schicht 20 bildet dadurch im aufgeblasenen Zustand des Hochspannungsleiters 17 einen hohlzylindrischen, sich um die Trägerstruktur 30 herumerstreckenden Schlauch.

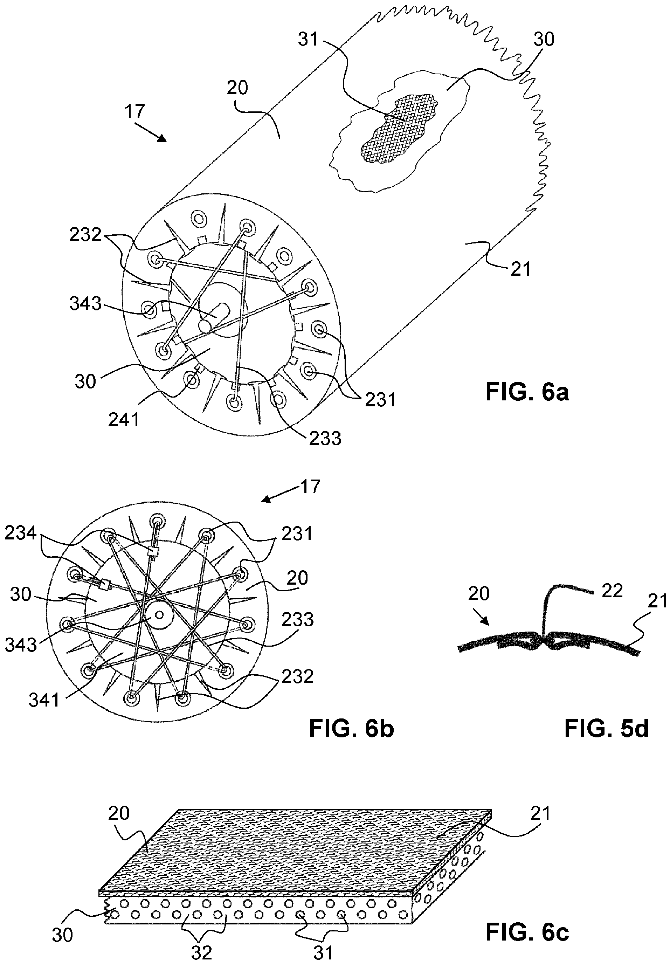

In der Figur 5d ist eine Variante der Längsnaht 22 gezeigt, bei welcher beide Ränder der elektrisch leitfähigen Schicht 20 im Nahtbereich umgeschlagen sind und auf der radialen Innenseite der elektrisch leitfähigen Schicht 20 aufliegen. Bei der Längsnaht 22 kann es sich insbesondere um eine Steppnaht handeln. Hierzu können in einem ersten Schritt die beiden Längsränder der elektrisch leitfähigen Schicht 20 miteinander vernäht werden, um einen Schlauch mit radial nach aussen vorstehender Naht zu bilden. Die Nahtüberstände können dann an die Aussenfläche des so gebildeten Schlauches z.B. angeklebt werden. In einem zweiten Schritt kann der Schlauch dann umgestülpt werden, so dass die Naht an der radialen Innenseite angeordnet ist. Der so gebildete Schlauch kann dann anschliessend glatt ausgestrichen werden. Auf diese Weise kann ein Hochspannungsleiter 17 mit einer elektrisch leitfähigen Schicht 20 hergestellt werden, deren Aussenfläche weitgehend glatt und homogen ist.

Zur Sicherung der elektrisch leitfähigen Schicht 20 an der Trägerstruktur 30 sind entlang der Kopfenden der elektrisch leitfähigen Schicht 20 in regelmässigen Abständen jeweils Ringösen 231 vorgesehen. Die Ringösen 231, welche vorteilhaft jeweils umlaufend von einem Metall umrandet sind, dienen zum Durchführen eines Schnürseils 233 (siehe Figuren 6a und 6b). Mittels beispielsweise sternförmigem Verschnüren der Ringösen 231 mit dem Schnürseil 233 kann die elektrisch leitfähige Schicht 20, wie es in den Figuren 6a und 6b gezeigt ist, an den Kopfenden der Trägerstruktur 30 gesichert werden. Um unkontrollierte Falten- und Rumpfbildungen an der elektrisch leitfähigen Schicht 20 zu verhindern, sind in Umfangsrichtung zwischen den Ringösen 231 vorteilhaft jeweils definierte Falze 232 vorgesehen, welche z.B. durch Verkleben fixiert werden können. Alternativ oder zusätzlich zu den Falzen 232 können auch Einschnitte in der elektrisch leitfähigen Schicht 20 vorgesehen sein. Mittels Seilklemmen 234 kann das Schnürseil 233 befestigt werden.

Der grundsätzliche Schichtaufbau des Hochspannungsleiters 17 ist schematisch in der Figur 6c dargestellt. Die Trägerstruktur 30 kann zur Verstärkung eine Gewebeeinlage 31 aufweisen, welches in einem Matrixmaterial 32 eingebettet ist. Das Vorsehen einer Gewebeeinlage 31 in der Trägerstruktur 30 ist insbesondere dann vorteilhaft, wenn die Form des Hochspannungsleiters 17 im aufgeblasenen Zustand durch die Trägerstruktur 30 definiert werden soll. Die Gewebeeinlage 31 kann dann dazu dienen, ein weiteres Aufblasen und Ausdehnen des Hochspannungsleiters 17 zu verhindern. Beim Matrixmaterial 32 handelt es sich bevorzugt um ein Kunststoffmaterial. Die im aufgeblasenen Zustand unmittelbar und satt auf der Trägerstruktur 30 aufliegende elektrisch leitfähige Schicht 20 wird durch ein Metallgewebe 21 gebildet. Beim Metallgewebe 21 handelt es sich um ein engmaschig verflochtenes, elektrisch leitfähiges Gewebe, welches für die Zwecke der Hochspannungsprüfung bzgl. ihrer elektrischen Wirksamkeit als eine insgesamt homogene Schicht angesehen werden kann. Bei der vorliegenden bevorzugten Ausführungsform wird das Metallgewebe 21 durch ein zuerst verkupfertes und dann versilbertes Polyestergewebe gebildet.

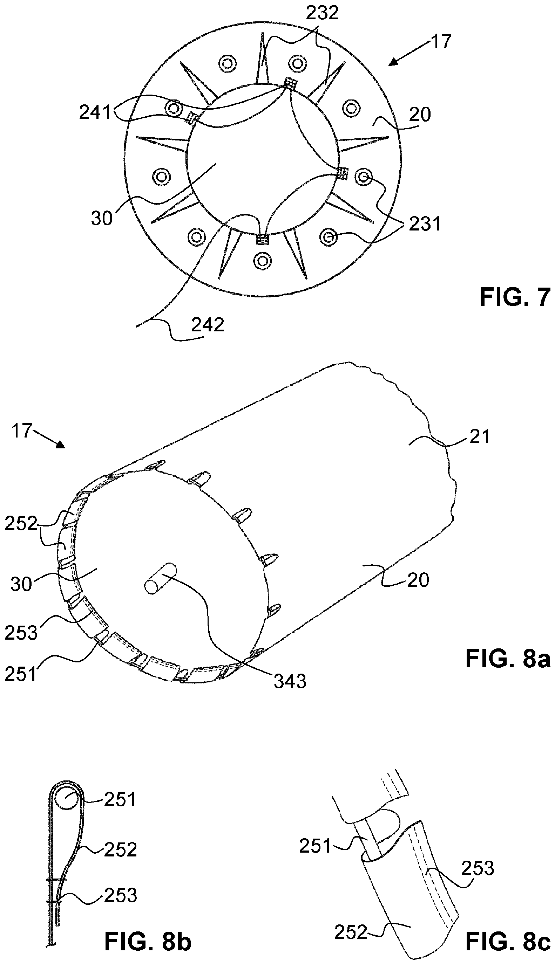

Die elektrische Kontaktierung der elektrisch leitfähigen Schicht 20 an den Kopfenden via ein elektrisches Anschlusskabel 242 ist in der Figur 7 dargestellt. In den Bereichen der Ringösen 231 sind jeweils elektrische Kontaktklemmen 241 vorgesehen, an denen das elektrische Anschlusskabel 242 anschliessbar ist. Das elektrische Anschlusskabel 242 kann dann mit einem elektrischen Verbindungskabel 101 (siehe Figur 1) gekoppelt werden oder selbst ein solches bilden.

Eine andere Variante zur Sicherung der elektrisch leitfähigen Schicht 20 an der Trägerstruktur 30 ist in den Figuren 8a bis 8d gezeigt. Anstelle von Ringösen 231 weist die elektrisch leitfähige Schicht 20 an ihren Kopfenden jeweils eine Vielzahl von Befestigungslaschen 252 auf, durch welche ein sich entlang des Umfangs erstreckendes Halteseil 251 durchgezogen ist. Die Befestigungslaschen 252 werden jeweils, wie in den Figuren 8b und 8c gezeigt, durch Zurückfalten eines Teils der elektrisch leitfähigen Schicht 20 und Befestigen mittels einer Naht 253 gebildet. Die Naht 253 kann zum Beispiel durch Vernähen, Verkleben und/oder Verschweissen erreicht werden. Indem die Naht 253 vernäht wird, kann eine besonders hohe Festigkeit erreicht werden.

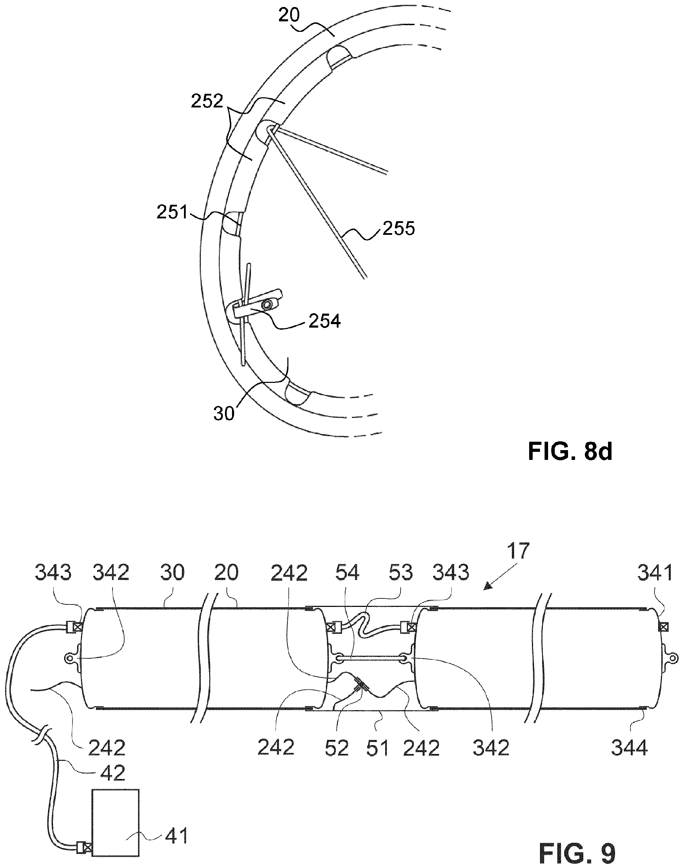

Die Enden des Halteseils 251 sind mittels einer Seilklemme 254 miteinander verbunden (siehe Figur 8d). Die Sicherung der elektrisch leitfähigen Schicht 20 an der Trägerstruktur 30 kann optional noch verbessert werden, indem das Halteseil 251 zwischen den Befestigungslaschen 252 mittels eines Schnürseils 255, beispielsweise wiederum sternförmig, festgeschnürt wird.

Eine Möglichkeit, um mit mehreren Hochspannungsleitern 17 eine grössere Länge zu erreichen, ist in der Figur 9 gezeigt. Hierzu werden zwei oder mehr Hochspannungsleiter 17 jeweils an ihren Kopfenden miteinander verbunden. Mechanisch erfolgt die Verbindung via die Halteringe 342 über eine mechanische Verbindung 54. Zur elektrischen Koppelung werden die elektrischen Anschlusskabel 242 der beiden Hochspannungsleiter 17 mittels einer Mehrfachbuchse 52 miteinander verbunden. Um im Hinblick auf Teilentladungen eine möglichst glatte Aussenoberfläche auch im Bereich zwischen den beiden Hochspannungsleitern 17 zu gewährleisten, ist im Verbindungsbereich umlaufend eine Rohrverbindung 51 vorgesehen, welche ebenfalls aus einem Metallgewebe 21 hergestellt ist. Als Rohrverbindung 51 kann insbesondere ein dünnwandiges metallisches Rohr dienen, welches einen Aussendurchmesser aufweist, der minimal kleiner ist (Bruchteile von mm oder wenige mm) als der Aussendurchmesser des aufgeblasenen Hochspannungsleiters 17, damit eine gute Festklemmung erfolgt und die Kanten der Rohrverbindung 51 entlang der gesamten Struktur nicht überstehen (und dadurch keine Teilentladungen erzeugen). Die Rohrverbindung 51 ist via ein elektrisches Anschlusskabel 242 mit der Mehrfachbuchse 52 verbunden. Da bei der Mehrfachbuchse 52 alle Buchsen untereinander elektrisch verbunden sind, ist somit die elektrisch leitende Rohrverbindung 51 mit den elektrisch leitfähigen Schichten 20 der beiden Hochspannungsleiter 17 elektrisch verbunden. Zur Weiterleitung der von einem Druckluftkompressor 41 via eine Druckluftanschlussleitung 42 in die erste Trägerstruktur 30 eingeleiteten Druckluft in die zweite Trägerstruktur 30 ist zwischen den beiden Hochspannungsleitern 17 eine Druckluftverbindung 53 vorgesehen. Auf diese Weise kann die zwischen zwei elektrotechnischen Komponenten mit einem Hochspannungsleiter überbrückbare Länge mittels Aneinanderreihung von mehreren kurzen Hochspannungsleiter 17 um ein Vielfaches vergrössert werden.

Da die vom Druckluftkompressor 41 zum Hochspannungsleiter 17 führende Druckluftanschlussleitung 42 einfach elektrisch isolierend ausgeführt werden kann, kann diese je nach Bedarf auch während der Hochspannungsprüfung angeschlossen bleiben, um zum Beispiel im Falle eines Druckabfalls den Druck im Hochspannungsleiter 17 mittels des Druckluftkompressors 41 wieder zu erhöhen bzw. konstant zu halten.

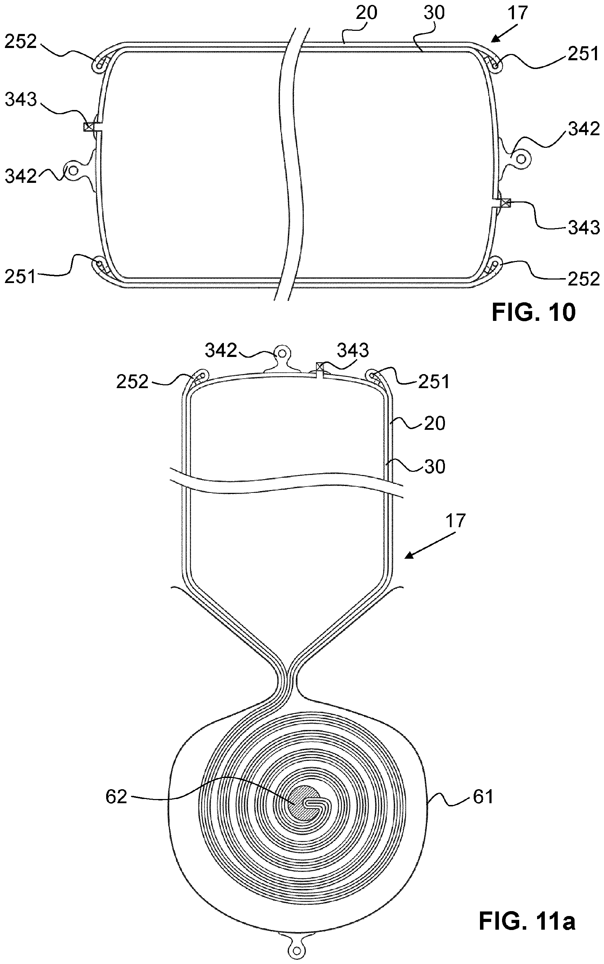

In der Figur 10 ist ein Hochspannungsleiter 17 gezeigt, der allein verwendbar ist, aber auch zur Aneinanderreihung mit weiteren identisch ausgebildeten Hochspannungsleiter 17 geeignet ist. Um die Aneinanderreihung zu ermöglichen, weist er insbesondere an beiden seiner Kopfenden jeweils einen Haltering 342 sowie ein Luftventil 343 auf.

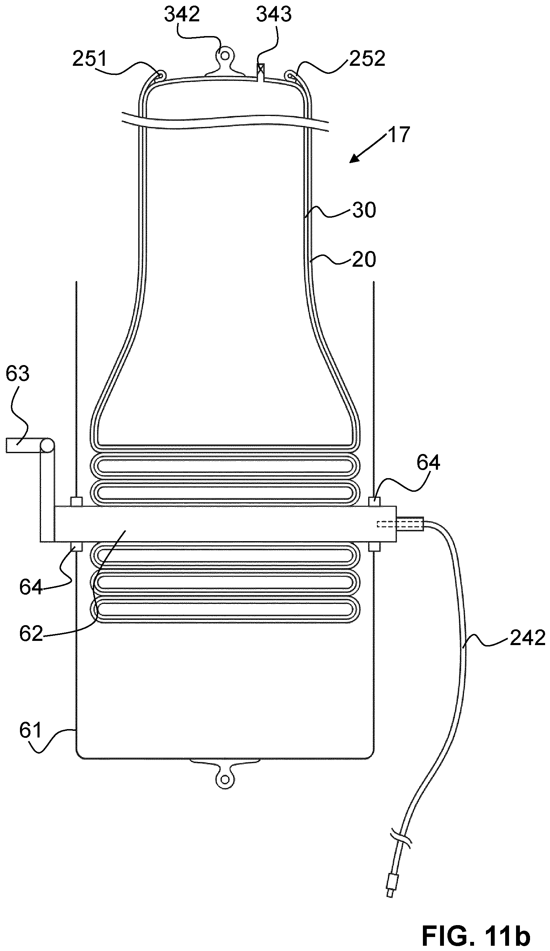

In den Figuren 11a und 11b ist eine bevorzugte Ausführungsform eines längenanpassbaren Hochspannungsleiters 17 gezeigt. Während das in den Figuren oben angeordnete Längsende wie vorausgehend beschrieben ausgebildet ist, ist das gegenüberliegende untere Längsende des Hochspannungsleiters 17 zwecks Längenanpassung einrollbar. Der Hochspannungsleiter 17 ist hierzu mit seinem unteren Kopfende in einer Aufrollachse 62 eingespannt und mittels einer Handkurbel 63 auf diese aufrollbar. Die Aufrollachse 62 ist dabei beidseitig in Lagern 64 gelagert, welche an einem Aufrollkasten 61 angebracht sind. Der Aufrollkasten 61 dient zur Aufnahme des aufgerollten Teils des Hochspannungsleiters 17. Die elektrische Kontaktierung der elektrisch leitfähigen Schicht 20 durch das Anschlusskabel 242 erfolgt via die Aufrollachse 62. Nach Erreichen der benötigten Ausrolllänge des längenanpassbaren Hochspannungsleiter 17, kann die Aufrollachse 62 gegen weitere Drehung blockiert werden. Dies kann zum Beispiel durch Umklappen des Griffes der Handkurbel 63 erfolgen, welche dann am Aufrollkasten 61 bei weiterer versuchter Drehung ansteht.

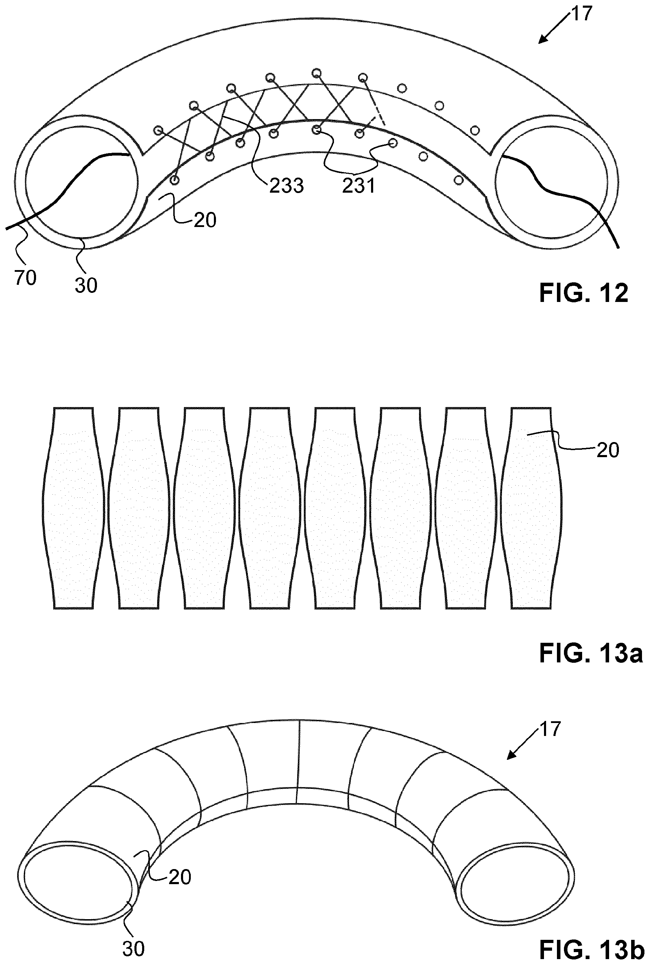

In der Figur 12 ist eine Ausführungsform eines Hochspannungsleiters 17 gezeigt, der sich im Gegensatz zu denjenigen der bisherigen Ausführungsformen nicht geradlinig erstreckt, sondern eine Krümmung beschreibt. Je nach Anwendung kann eine solche Form vorteilhaft sein. Anstelle einer Längsnaht 22 sind die Seitenränder der elektrisch leitfähigen Schicht 20 hier zudem nicht nur kopfseitig, sondern auch längsseitig mittels Ringösen 231 und eines Schnürseils 233 miteinander verbunden. Die elektrisch leitfähige Schicht 20 umgibt die Trägerstruktur 30 dadurch in Umfangsrichtung nicht ganz vollständig, was jedoch insbesondere dann problemlos tolerierbar ist, wenn die Teilentladungen mehr auf der konvexen Seite der Krümmung des Hochspannungsleiters 17, kaum jedoch auf dessen konkaven Seite drohen. Im Inneren der Trägerstruktur 30 ist bei der Ausführungsform der Figur 12 zudem ein elektrischer Innenleiter 70 angeordnet, der sich über die gesamte Längserstreckung des Hochspannungsleiters erstreckt und zum Übertragen von zusätzlicher elektrischer Energie dient.

Um unkontrollierte Falten- und Rumpfbildungen an der elektrisch leitfähigen Schicht 20 zu verhindern, können bei der Ausführungsform der Figur 12 entlang den Seitenrändern zwischen den Ringösen 231 vorteilhaft jeweils definierte Falze vorgesehen sein, welche z.B. durch Verkleben fixiert werden können. Alternativ oder zusätzlich zu den Falzen können auch Einschnitte in der elektrisch leitfähigen Schicht 20 vorgesehen sein.

Um Falten- und Rumpfbildungen bei einer solchen Ausführungsform gänzlich zu vermeiden, kann die elektrisch leitfähige Schicht 20 auch in mehrere Segmente geschnitten werden, welche die in der Figur 13a gezeigte geometrische Form aufweisen. Wenn die einzelnen Segmente anschliessend geeignet miteinander vernäht, verklebt und/oder verschweisst werden, kann eine elektrisch leitfähige Schicht 20 mit einer falten- und rumpffreien gebogenen Schlauchform erreicht werden, wie sie in der Figur 13b gezeigt ist.

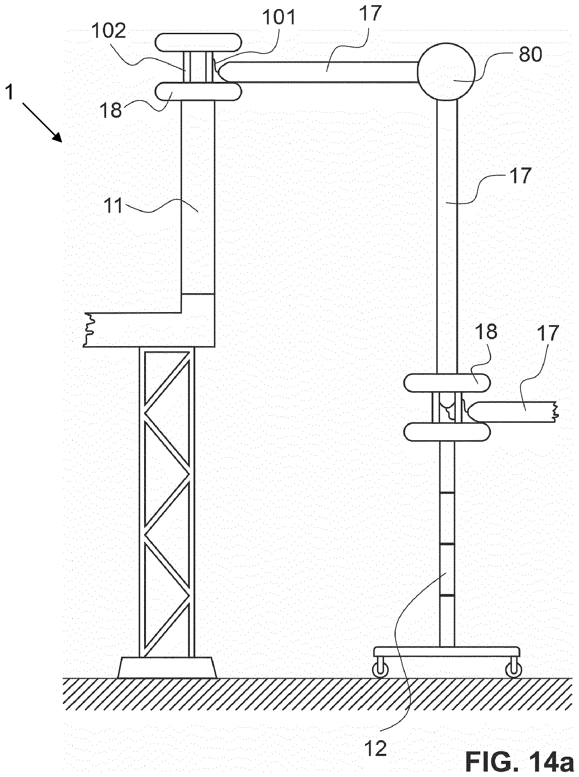

In der Figur 14a ist ein Ausschnitt eines weiteren Hochspannungsprüfaufbaus 1 zum Prüfen einer Hochspannungsanlage unter Verwendung von erfindungsgemässen Hochspannungsleitern 17 sowie einem Eckverbindungselement 80 gezeigt.

Die Anschlüsse der Einspeisedurchführungen 11 können sich je nach Betriebsspannungsebene und Anlagenkonstruktion auf grossen Höhen von zum Beispiel 10 Meter oder mehr befinden. Bei beschränktem Platz für den Hochspannungsprüfaufbau 1 in der Nähe der Einspeisedurchführungen 11 ist es deshalb oft von Vorteil, über eine Kombination von senkrecht und waagrecht angeordneten Hochspannungsleitern 17 eine Verbindung zwischen der oder den Einspeisedurchführungen 11 und dem restlichen Hochspannungsprüfaufbau 1 herzustellen.

In Figur 14a ist ein Beispiel für eine Verbindung eines senkrechten Hochspannungsleiters 17 mit einem horizontalen Hochspannungsleiter 17 mittels einem kugelförmigen Eckverbindungselement 80 schematisch abgebildet. Das untere Ende des vertikalen Hochspannungsleiters 17 ist im Bereich der Abschirmtoroide 18 des Messteilers 12 mechanisch fixiert. Das obere Ende ist im Eckverbindungselement 80 fixiert, in dem sich auch das eine Ende des waagerechten Hochspannungsleiters 17 befindet und dort fixiert ist. Das andere Ende des waagerechten Hochspannungsleiters 17 ist an der Einspeisedurchführung 11 angeschlossen. Grundsätzlich sind auch Verbindungen der Hochspannungsleiter 17 mit beliebigen anderen Winkeln als den in der Figur 14a dargestellten 90° möglich.

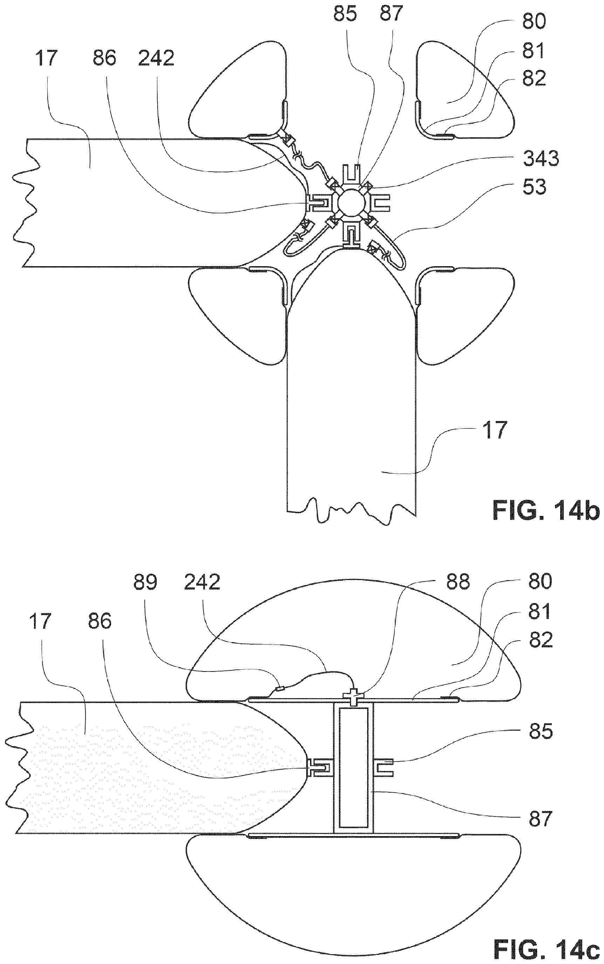

Die Figuren 14b und 14c zeigen vergrösserte Schnittansichten des Prüfaufbaus im Bereich des Eckverbindungselements 80. Die Aussenhülle des Eckverbindungselements 80 wird bevorzugt genauso wie jeweils bei den Hochspannungsleitern 17 aus einer Trägerstruktur 30 und einer elektrisch leitfähigen Schicht 20 gebildet und ist aufblasbar. Die Formgebung kann durch entsprechend geformte und zusammengefügte Segmente für die Schicht der Trägerstruktur 30 sowie die elektrisch leitfähige Schicht 20 erreicht werden. Im Innern des Eckverbindungselements 80 befindet sich ein gasdichtes Rohrkreuz 81, welches über Verbindungsstellen 82 gasdicht mit der Aussenhülle des Eckverbindungselements 80 verbunden ist. Das Rohrkreuz 81 dient zur Aufnahme und zum Fixieren der Enden der Hochspannungsleiter 17. Im Innern des Rohrkreuzes 81 ist ein Anschlussblock 87 befestigt, welcher zur mechanischen, elektrischen und pneumatischen Verbindung der beiden Hochspannungsleiter 17 dient. Der Anschlussblock 87 weist einen elektrisch leitenden Hohlkörper auf, welcher auf seiner Aussenseite über elektrische Anschlüsse in Form von Arretierkontaktbuchsen 85 und über Druckluftanschlüsse mit Verbindung zum Hohlkörper-Innenraum in Form von Luftventilen 343 verfügt. Via den Anschlussblock 87 und insbesondere den Innenraum des aufblasbaren Eckverbindungselements 80 wird somit ein Zusammenschluss der Druckluftversorgung der beiden Hochspannungsleiter 17 erreicht.

Die Enden der gezeigten Ausführung der Hochspannungsleiter 17 sind konisch ausgeführt, was eine einfachere Konstruktion des Kopfteiles 341 sowie eine einfachere Einführung der Hochspannungsleiter 17 in das Eckverbindungselement 80 ermöglicht. Die Druckluftverbindung zwischen den beiden Hochspannungsleitern 17 via den Anschlussblock 87 erfolgt mittels Druckluftverbindungen 53. Die mechanische Fixierung sowie die elektrische Kontaktierung der Hochspannungsleiter 17 erfolgen kombiniert durch ein mechanisch arretierbares Kontaktsystem mittels eines Arretierkontaktsteckers 86 und einer Arretierkontaktbuchse 85. Der Arretierkontaktstecker 86 ist hierzu mechanisch am Kopfteil des jeweiligen Hochspanungsleiters 17 fixiert und via das elektrische Anschlusskabel 242 mit der elektrisch leitfähigen Schicht 20 des Hochspannungsleiters 17 verbunden. Die Arretierkontaktbuchse 85 ist mechanisch und elektrisch mit dem Anschlussblock 87 verbunden. Beim Einstecken des Arretierkontaktsteckers 86 in der Arretierkontaktbuchse 85 wird diese bevorzugt automatisch mechanisch verriegelt, so dass die Verbindung einem mechanischen Zug auf das Kontaktsystem standhält. Die Verriegelung kann bevorzugt durch erneuten Druck auf das Kontaktsystem (Arretierkontaktstecker 86 und Arretierkontaktbuchse 85) gelöst werden. Solche Arretierkontaktstecker 86 und dazugehörige Arretierkontaktbuchsen 85 sind bereits bekannt (z.B. der einpolige, unisolierte Rundsteckverbinder von Stäubli International AG, Schweiz).

Der Stromfluss erfolgt somit vom vertikalen Hochspannungsleiter 17 via das elektrische Anschlusskabel 242 über den Arretierkontaktstecker 86 auf die Arretierkontaktbuchse 85, und von dieser auf den elektrisch leitenden Anschlussblock 87, welcher vorzugsweise aus einem Metall hergestellt ist. Vom elektrisch leitenden Anschlussblock 87 erfolgt der Stromfluss weiter via die andere Arretierkontaktbuchse 85, und von der anderen Arretierkontaktbuchse 85 via den Arretierkontaktstecker 86 des horizontalen Hochspannungsleiters 17 über das elektrische Anschlusskabel 242 zur elektrisch leitfähigen Schicht 20 des horizontalen Hochspannungsleiters 17.

Die elektrisch leitfähige Schicht 20 der aufblasbaren Hülle des Eckverbindungselement 80 ist via ein elektrisches Kopplungselement 89 über ein elektrisches Anschlusskabel 242 mit einem gasdicht montierten Durchführungskontakt 88 elektrisch verbunden. Der Durchführungskontakt 88 ist mit dem Anschlussblock 87 elektrisch verbunden, womit also die elektrisch leitfähige Schicht 20 der Hülle des Eckverbindungselements 80 mit dem Anschlussblock 87, und somit auch mit den elektrisch leitfähigen Schichten 20 der horizontalen und vertikalen Hochspannungsleiter 17 über definierte Kontakte und elektrische Leiter elektrisch verbunden ist.

Aufgrund der elektrisch leitfähigen, aufblasbaren Aussenhülle des Eckverbindungselements 80 sind somit alle darin angeordneten Anschlussteile elektrisch gegenüber der Umgebung abgeschirmt. Das Aufblasen des Eckverbindungselements 80 kann zusammen mit den beiden Hochspannungsleitern 17 oder separat davon erfolgen.

Die Erfindung ist selbstverständlich nicht auf die vorstehend beschriebenen Ausführungsformen beschränkt, sondern eine Vielzahl von Modifikationen sind möglich. So muss die elektrisch leitfähige Schicht beispielsweise nicht zwingend ausserhalb der Trägerstruktur angeordnet sein, sondern könnte sich genauso gut auch radial innerhalb der Trägerstruktur befinden. Zur Sicherung der elektrisch leitfähigen Schicht im aufgeblasenen Zustand an der Trägerstruktur sind eine Vielzahl von anderen als der hier beschriebenen Möglichkeiten denkbar. Beispielsweise könnte die elektrisch leitfähige Schicht auch mit der Trägerstruktur verklebt sein oder das Matrixmaterial 32 der Trägerstruktur könnte auch das Metallgewebe 21 umgeben. Anstatt als Metallgewebe könnte die elektrisch leitfähige Schicht auch anders ausgebildet sein. Zum Beispiel könnte sie durch eine auf eine Folie oder sogar direkt auf die Trägerstruktur aufgetragene Metallbeschichtung gebildet sein. Bei der Ausführungsform der Figuren 6a-c könnte selbstverständlich zusätzlich ein Haltering 342 an der Trägerstruktur 30 angebracht sein, ähnlich wie dies bei den Ausführungsformen der Figuren 4a-b, 9, 10 sowie 11a-b der Fall ist. Bei all diesen Ausführungsformen wäre eine Anbringung des Halterings 342 zudem grundsätzlich auch an der elektrisch leitfähigen Schicht 20 denkbar. Eine Vielzahl weiterer Modifikationen und Abwandlungen sind denkbar.

**BEZUGSZEICHENLISTE**

| | | | |
|---|---|---|---|
| 1 | Hochspannungsprüfaufbau | 30 | Trägerstruktur |
| 11 | Einspeisedurchführung | 31 | Gewebeeinlage |
| 12 | Messteiler | 32 | Matrixmaterial |
| 13 | Drosseln | 33 | Längsnaht |
| 14 | Erregungstransformator | | |
| 15 | Umrichter | 341 | Kopfteil |
| 16 | Isoliertransformator | 342 | Haltering |
| 17 | Hochspannungsleiter | 343 | Luftventil |
| 18 | Abschirmtoroid | 344 | Verbindungsstelle |
| 101 | Elektrisches | 41 | Druckluftkompressor |
| | Verbindungskabel | 42 | Druckluftanschlussleitung |
| 102 | Distanzhalter | | |
| 103 | Elektrisches | 51 | Rohrverbindung |
| | Verbindungskabel | 52 | Mehrfachbuchse |
| | | 53 | Druckluftverbindung |
| 20 | Elektrisch leitfähige Schicht | 54 | Mechanische Verbindung |
| 21 | Metallgewebe | | |
| 22 | Längsnaht | 61 | Aufrollkasten |
| | | 62 | Aufrollachse |
| 231 | Ringöse | 63 | Handkurbel |
| 232 | Falz | 64 | Lager |
| 233 | Schnürseil | | |
| 234 | Seilklemme | 70 | Innenleiter |
| 241 | Elektrische Kontaktklemme | 80 | Eckverbindungselement |
| 242 | Elektrisches Anschlusskabel | 81 | Rohrkreuz |
| | | 82 | Verbindungsstelle |
| 251 | Halteseil | 85 | Arretierkontaktbuchse |
| 252 | Befestigungslasche | 86 | Arretierkontaktstecker |
| 253 | Naht | 87 | Anschlussblock |
| 254 | Seilklemme | 88 | Durchführungskontakt |
| 255 | Schnürseil | 89 | Elektrisches Kopplungselement |

## Patentansprüche

1. Elektrischer Hochspannungsleiter (17) zur Übertragung von elektrischer Energie bei der Prüfung von Hochspannungsanlagen, aufweisend
eine elektrisch leitfähige Schicht (20) zum Leiten der elektrischen Energie durch den Hochspannungsleiter (17); sowie
eine Trägerstruktur (30), welche zum Tragen der elektrisch leitfähigen Schicht (20) dient,
**dadurch gekennzeichnet, dass**
die Trägerstruktur (30) mittels eines Gases in eine schlauchartige Form aufblasbar ist.

2. Hochspannungsleiter (17) nach Anspruch 1, wobei der Hochspannungsleiter (17) zu Lagerungs- und/oder Transportzwecken zumindest teilweise, bevorzugt ganz, entlang seiner Hauptlängserstreckung aufrollbar ist.

3. Hochspannungsleiter (17) nach einem der vorhergehenden Ansprüche, wobei die elektrisch leitfähige Schicht (20) ein Metallgewebe (21) aufweist.

4. Hochspannungsleiter (17) nach Anspruch 3, wobei es sich beim Metallgewebe (21) um ein metallisiertes Kunststoffgewebe, insbesondere um ein metallisiertes Polyestergewebe, handelt.

5. Hochspannungsleiter (17) nach einem der vorhergehenden Ansprüche, wobei die Form des Hochspannungsleiters (17) im aufgeblasenen Zustand durch die elektrisch leitfähige Schicht (20) definiert ist.

6. Hochspannungsleiter (17) nach einem der Ansprüche 1 bis 4, wobei die Form des Hochspannungsleiters (17) im aufgeblasenen Zustand durch die Trägerstruktur (30) definiert ist.

7. Hochspannungsleiter (17) nach einem der vorhergehenden Ansprüche, wobei die Trägerstruktur (30) das Hauptgewicht des Hochspannungsleiters (17) bildet.

8. Hochspannungsleiter (17) nach einem der vorhergehenden Ansprüche, wobei die elektrisch leitfähige Schicht (20) das Hauptgewicht des Hochspannungsleiters (17) bildet.

9. Hochspannungsleiter (17) nach einem der vorhergehenden Ansprüche, wobei die elektrisch leitfähige Schicht (20) und die Trägerstruktur (30) lose aufeinander liegen.

10. Hochspannungsleiter (17) nach einem der vorhergehenden Ansprüche, welcher mehrere elektrisch leitfähige Schichten (20) aufweist, wobei der Hochspannungsleiter (17) ausserdem bevorzugt eine oder mehrere Zwischenschichten aufweist, welche zwischen jeweils zwei elektrisch leitfähigen Schichten (20) angeordnet sind und zur Verminderung der Reibung zwischen den beiden elektrisch leitfähigen Schichten (20) dienen.

11. Hochspannungsleiter (17) nach einem der vorhergehenden Ansprüche, wobei an einem oder beiden Kopfenden der elektrisch leitfähigen Schicht (20) Ringösen (231) und/oder Laschen (252) vorgesehen sind, um die elektrisch leitfähige Schicht (20) mittels eines Schnür- oder Halteseils (233, 251, 255) an der Trägerstruktur (30) zu befestigen.

12. Hochspannungsleiter (17) nach einem der vorhergehenden Ansprüche, wobei die Trägerstruktur (30) eine Gewebeeinlage (31) aufweist.

13. Hochspannungsleiter (17) nach einem der vorhergehenden Ansprüche, wobei die Trägerstruktur (30) im aufgeblasenen Zustand gasdicht verschliessbar ist.

14. Hochspannungsleiter (17) nach einem der vorhergehenden Ansprüche, wobei die Gesamtlänge des Hochspannungsleiters (17) im aufgeblasenen Zustand anpassbar ist, indem die Trägerstruktur (30) und bevorzugt die elektrisch leitfähige Schicht (20) entlang ihrer Hauptlängserstreckungen teilweise aufgerollt werden.

15. Hochspannungsleiter (17) nach einem der vorhergehenden Ansprüche, ausserdem aufweisend einen im Inneren der Trägerstruktur (30) angeordneten Innenleiter (70) zum Übertragen von zusätzlicher elektrischer Energie.

16. Verfahren zur Prüfung einer Hochspannungsanlage, wobei zwei elektrotechnische Komponenten (11, 12, 13) mittels eines elektrischen Hochspannungsleiters (17), insbesondere mittels eines Hochspannungsleiters (17) nach einem der vorhergehenden Ansprüche, miteinander verbunden werden, der eine elektrisch leitfähige Schicht (20) aufweist, welche zum Übertragen der elektrischen Energie zwischen den beiden elektrotechnischen Komponenten (11, 12, 13) ausgebildet ist, sowie eine Trägerstruktur (30) hat, welche zum Tragen der elektrisch leitfähigen Schicht (20) dient,
**dadurch gekennzeichnet, dass**
die Trägerstruktur (30) mittels eines Gases in eine schlauchartige Form aufgeblasen wird.
